# EUROPÄISCHE PATENTSCHRIFT

(11) **EP 0 859 953 B1**
(45) Veröffentlichungstag und Bekanntmachung des Hinweises auf die Patenterteilung: **20.09.2000**
(21) Anmeldenummer: 96938117.7
(22) Anmeldetag: 06.11.1996
(51) Int. Cl.: G01N 23/18, H05K 13/08

(54) **VERFAHREN UND ANORDNUNG ZUR PRÜFUNG VON LÖTSTELLEN**
PROCESS AND ARRANGEMENT FOR TESTING SOLDER JOINTS
PROCEDE ET DISPOSITIF POUR TESTER DES BRASURES

(30) Priorität: 06.11.1995 DE 19541322
(43) Veröffentlichungstag der Anmeldung: 26.08.1998
(73) Patentinhaber: MACROTRON PROCESS TECHNOLOGIES GMBH, 85551 Kirchheim (DE)
(72) Erfinder: SPERSCHNEIDER, Eckhard, D-85579 Neubiberg (DE)
(74) Vertreter: Dosterschill, Peter, Dr.
(86) Internationale Anmeldenummer: EP9604853
(87) Internationale Veröffentlichungsnummer: WO9717605

(56) Entgegenhaltungen:
- EP-A- 0 236 001
- EP-A- 0 723 390
- US-A- 5 291 535
- I.E.E.E. TRANSACTIONS ON COMPONENTS, PACKAGING AND MANUFACTURING TECHNOLOGY: PART A, Bd. 17, Nr. 2, 1.Juni 1994, Seiten 270-276, XP000455263 FELDMANN K ET AL: "CLOSED LOOP QUALITY CONTROL IN PRINTED CIRCUIT ASSEMBLY"
- PARK J S ET AL 'A SOLDER JOINT INSPECTION SYSTEM FOR AUTOMATED PRINTED CIRCUIT BOARD MANUFACTURING' PROCEEDINGS OF THE INTERNATIONAL CONFERENCE ON ROBOTICS AND AUTOMATION, CINCINNATI, MAY 13 - 18, 1990 Bd. 2, 13 Mai 1990, INSTITUTE OF ELECTRICAL AND ELECTRONICS ENGINEERS, Seiten 1290 - 1295, XP000143745
- DRIELS M R ET AL: 'AUTOMATIC DEFECT CLASSIFICATION OF PRINTED WIRING BOARD SOLDER JOINTS' IEEE TRANSACTIONS ON COMPONENTS, HYBRIDS AND MANUFACTURING TECHNOLOGY Bd. 13, Nr. 2, 01 Juni 1990, Seiten 331 - 340, XP000179243
- TEST AND MEASUREMENT WORLD. (INC. ELECTRONICS TEST ), Bd. 11, Nr. 3, 15.Februar 1991, Seiten 21-22, XP000175086 SORON E: "X-RAY SYSTEMS KEEP PACE WITH SMT"

## Beschreibung

Die Erfindung betrifft ein Verfahren und eine Anordnung zur Prüfung von Lötstellen nach dem Oberbegriff der Ansprüche 1 bzw. 5.

Die Qualität von Lötstellen auf Leiterplatten kann mittels Röntgenstrahlung auf Fehler überprüft werden. Dabei werden lötstellenindividuelle Qualitätsinformationen gebildet, wobei für jede Lötstelle entweder die Information "Lötstelle fehlerfrei" oder die Information "Lötstelle fehlerhaft" gebildet wird. Diese Informationen werden leiterplattenbezogen ausgedruckt, wobei dieser Ausdruck zusammen mit der zugehörigen Leiterplatte einem Reparaturarbeitsplatz zugeführt wird. Dort werden die Leiterplatten, die mindestens eine Lötstelle aufweisen, für die die Information "Lötstelle fehlerhaft" gebildet wurde, einer Nachbehandlung unterzogen, wobei die angeblich fehlerhafte Lötstelle visuell überprüft wird. Ergibt sich dabei, daß die Lötstelle tatsächlich fehlerhaft ist, wird die Kontaktstelle mit der ursprünglichen fehlerhaften Lötstelle erneut gelötet. Im Anschluß daran wird erneut geprüft, ob diese Lötstelle nunmehr fehlerfrei ist. Diese Arbeiten werden in einem Protokoll vermerkt, das gegebenenfalls für statistische Auswertungen zur Verfügung steht.

Aus EP 0 236 001 B1 ist bereits ein Verfahren und eine Vorrichtung zum Messen struktureller Eigenschaften ausgewählter Bereiche einer hergestellten Leiterplatte mit darauf vorgesehenen Lötstellen bekannt. Die Vorrichtung weist eine Röntgeneinrichtung zum Erzeugen eines Röntgenstrahls auf, eine Abbildungseinrichtung zum Erfassen der durch die Leiterplatte übertragenen Röntgenstrahlen zum Erzeugen eines entsprechenden elektronischen Bildes, eine Verarbeitungseinrichtung zum Umwandeln des elektronischen Bildes in ein nach einer Grauskala kodiertes Bild und eine Recheneinrichtung, die Messungen auf dem nach einer Grauskala kodierten Bildes auf der Grundlage aus einer Datenbibliothek ausgewählter Meßalgorithmen ausführt, die sich auf vorgebbare elektronische Standard-Bauteile und Anordnungen sowie auf bestimmte Arten von hiermit verbundenen Lötstellendefekten (u.a. "solder ball", "excess solder", "cold solder joint"), beziehen. Die Recheneinrichtung erzeugt weiterhin ein Ausgangssignal, das einer Änderung der Messungen des nach einer Grauskala kodierten Bildes von vorbestimmten Meßstandards entspricht, die ihrerseits gewünschten, in der Bibliothek enthaltenen strukturellen Eigenschaften entsprechen. Das Ausgangssignal kann auch Meßdaten zur Prozeßsteuerung in Zukunft gefertigter gedruckter Schaltungen enthalten. Diese Meßdaten werden jedoch nicht in dem laufenden Produktionsprozeß verwendet, in dem die Eigenschaften der Leiterplatten gemessen werden.

Ein Verfahren zur Unterstützung der Reparatur defekter Substrate ist in der nachveröffentlichten EP-A- 723 390 offenbart.

Verfahren zur Prüfung von Lötstellen sind auch aus dem US-Patent 5,291,535, aus Soron, E.: "X-Ray Systems Keep Pace with SMT", in Test & Measurement World incorp. Electronic Test 11 (1991) February 15, No. 3, San Francisco, CA, US, Seiten 21/22 und aus Driels, M.R. and Nolan, D.J.: "Automatic Defect Classification of Printed Wiring Board Solder Joints", in IEEE Transactions on Components, Hybrids, and Manufacturing Technology 13 (1990) No. 2, New York, US, Seiten 331 - 340 bekannt.

Weiterhin ist aus Feldmann, K. und Sturm, J.: Closed Loop Quality Control in Printed Circuit Assembly , in IEEE Transactions on Components, Packaging and Manufacturing Technology - Part A 17 (1994) June, No. 2, New York, US, Seiten 270 - 276 ein Verfahren zur Prüfung von Lötstellen auf Leiterplatten bekannt. Die Qualität der Lötstellen wird mittels einer Röntgeninspektionseinrichtung geprüft. Diese generiert Röntgenbilder der Lötstellen und eine Liste mit tatsächlichen und vermeintlichen Fehlern (Pseudofehlern) und führt die Fehlerliste einer Reparaturstation zu.

An der Reparaturstation wird ein Lichtstrahl auf tatsächlich und vermeintlich fehlerhafte Lötstellen geführt. Damit wird an der Reparaturstation eine lokale Anzeige tatsächlich und vermeintlich fehlerhafter Lötstellen auf der Leiterplatte selbst gebildet. Die Bedienperson an der Reparaturstation nimmt eine Fehlerverifizierung anhand der genannten lokalen Anzeige tatsächlich oder vermeintlich fehlerhafter Lötstellen vor.

Ausgehend von diesem Stand der Technik liegt der Erfindung die Aufgabe zugrunde, ein Verfahren und eine Anordnung der eingangs genannten Art anzugeben, welche die Qualität der Prüfung von Lötstellen verbessern.

Diese Aufgabe wird erfindungsgemäß mit einem Verfahren und einer Anordnung gelöst, welche in den Ansprüchen definiert sind.

Die Erfindung ist mit einer Mehrzahl von Vorteilen verbunden.

Es ist z.B. nicht erforderlich, die Leiterplatten mit den tatsächlich oder vermeintlich fehlerhaften Lötstellen der Reparaturarbeitsstation zuzuführen, vielmehr können die Leiterplatten an einem anderen Ort verbleiben.

Vorteilhafte Ausgestaltungen der Erfindung sind in den Unteransprüchen gekennzeichnet.

Die Erfindung wird nun anhand der Zeichnungen beschrieben.

Es zeigt:
- Fig. 1: eine Anordnung von Einrichtungen im Zusammenhang mit der Durchführung des erfindungsgemäßen Verfahrens;
- Fig. 2: eine im Rahmen des erfindungsgemäßen Verfahrens gebildete Bildschirmanzeige eines Einzelfehlers;
- Fig. 3: eine im Rahmen des erfindungsgemäßen Verfahrens gebildete Bildschirmanzeige einer Fehlerliste;
- Fig. 4: eine im Rahmen des erfindungsgemäßen Verfahrens gebildete Bildschirmanzeige eines Röntgenbildes einer Leiterplatte mit Lötstellen;
- Fig. 5: eine im Rahmen des erfindungsgemäßen Verfahrens gebildete Bildschirmanzeige von Fehlern (Häufung von Fehlern an einer oder mehreren Stellen der Leiterplatte) in einer grafischen Darstellung des Leiterplattenlayouts;
- Fig. 6, 7 und 8: im Rahmen des erfindungsgemäßen Verfahrens gebildete Bildschirmanzeigen von Fehlern in statistischer Auswertung;
- Fig. 9: den Ablauf eines Zyklus im Zusammenhang mit der Verifizierung fehlerfreier Leiterplatten und der Reparatur fehlerhafter Leiterplatten;
- Fig. 10: im Rahmen des erfindungsgemäßen Verfahrens gebildete Bildschirmanzeigen von Meßwerten bzw. Fenstern zur Meßwertauswahl; und
- Fig. 11 bis 14: im Rahmen des erfindungsgemäßen Verfahrens gebildete Bildschirmanzeigen im Zusammenhang mit der Konfiguration von Meßwerten bzw. von Referenzwerten.

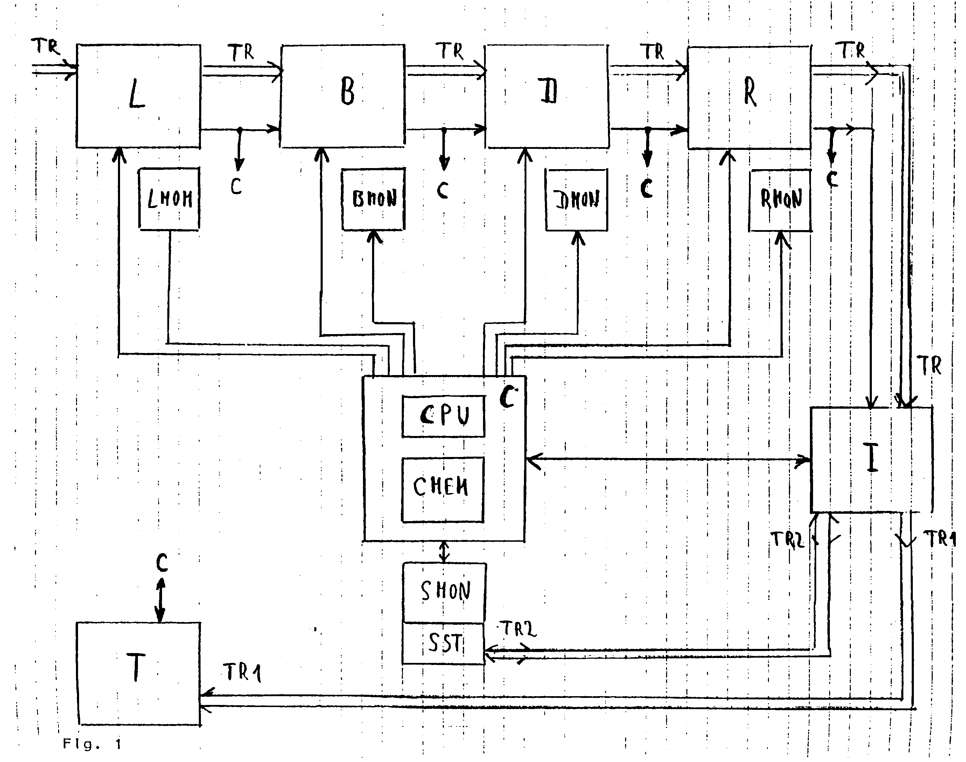

Die in Figur 1 dargestellte Anordnung besteht aus einer ersten Einrichtung L, die auf Leiterplattenrohlinge Lötpaste aufträgt, aus einer sogenannten Dispensen-Einrichtung D, aus einer zweiten Einrichtung B, die durch einen Bestückungsautomaten gebildet ist, der die Leiterplatten vorzugsweise in SMD-Technik mit einer oder mehreren Bauelementen bzw. Baugruppen bestückt, aus einer dritten Einrichtung R, die durch eine Reflow-Löteinrichtung gebildet ist, aus einer Röntgeninspektionseinrichtung I, aus einer Datenverarbeitungseinrichtung C, aus einer Reparaturarbeitsstation SST, die auch für die Verifizierung fehlerfreier Leiterplatten ausgestattet ist (Monitor SMON, der von C generierte Daten anzeigt) und ein nicht dargestelltes Keyboard zur Steuerung der Monitoranzeige bzw. zur Dialogführung mit der Datenverarbeitungseinrichtung C aufweist, sowie aus einer Einrichtung T, die elektrische Baugruppentests durchführt.

Die Einrichtungen L, D, B, R, I und T sind an sich bekannte Einrichtungen. Als Einrichtung L wird beispielsweise ein Produkt der Firma MPM mit der Produktbezeichnung Ultraprint verwendet; als Einrichtung D wird beispielsweise ein Produkt der Firma Cama/lot der 3000-er Serie verwendet; als Einrichtung B wird beispielsweise ein SMD-Bestückungsautomat der Firmen Siemens, Quad, Fuji oder Panasonica MPM verwendet; als Einrichtung R wird beispielsweise ein Ofen der Firma BTU oder ein entsprechendes Produkt der Firma Elektrovert verwendet; als Einrichtung I wird beispielsweise ein Produkt der Firma NICOLET (NIS) mit der Produktbezeichnung CX13000/5000 und MV6000 verwendet, und als Einrichtung T wird beispielsweise ein Produkt der Firma Hewlett Packard mit der Produktbezeichnung HP 3070 verwendet.

Den Einrichtungen L, B, D, R sowie der Reparaturarbeitsstation SST sind Bildschirmmonitore LMON, BMON, DMON, RMON und SMON zugeordnet, die mit der Datenverarbeitungseinrichtung C verbunden sind.

Der Datenverarbeitungseinrichtung C ist ein das erfindungsgemäße Verfahren definierendes Steuerungsprogramm zugeordnet. Sie ist in Figur 1 schematisch mit ihrem Steuerwerk CPU und mit einem Speicher CMEM angegeben, der u.a. der Aufnahme der Informationen dient, die im Rahmen des erfindungsgemäßen Verfahrens gebildet werden bzw. auf die zur Bildung dieser Informationen zugegriffen wird. Die Datenverarbeitungseinrichtung ist mit den Einrichtungen L, D, B, R, I und T verbunden. Die Datenverarbeitungseinrichtung C erhält von diesen Einrichtungen erste Daten, die die in diesen Einrichtungen behandelten Leiterplatten betreffen, und/oder zweite Daten, die die Einrichtungen selbst betreffen. Die ersten und/oder zweiten Daten können auch von einer Einrichtung (z.B. L) der jeweils nachgeordneten Einrichtung (z.B: B) zugeführt werden. Die Datenverarbeitungseinrichtung C führt den Einrichtungen L, B, D und R Steuer- bzw. Regelinformationen zu, die in Abhängigkeit von lötstellenindividuellen Qualitätsinformationen und/oder den lötstellenindividuellen Meßwertinformationen gebildet werden.

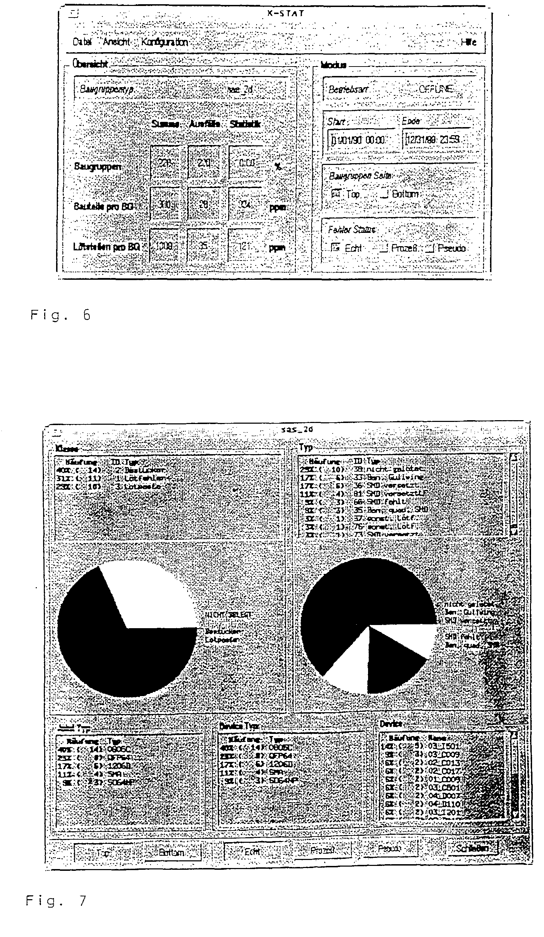

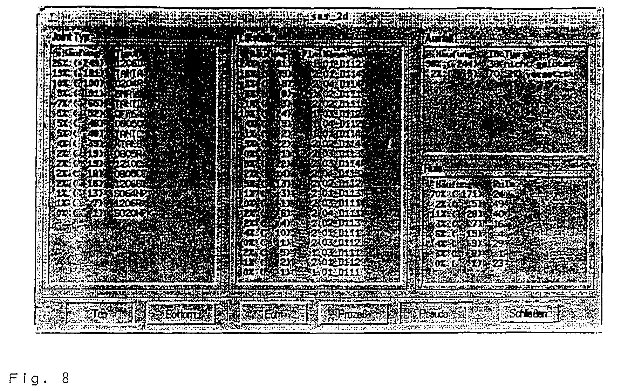

Den Monitoren LMON, BMON, DMON, RMON und SMON führt die Datenverarbeitungseinrichtung C u.a. lötstellenindividuelle Qualitätsinformationen, lötstellenindividuelle Meßwertinformation und gegebenenfalls statistische Informationen über die Häufigkeit des Auftetens von Fehlern zu. Diese Informtionen werden auf den Monitoren angezeigt. In den Figuren 6 bis 8 und 10 sind derartige Bilschirmanzeigen dargestellt.

Der Transportweg der Leiterplatten ist in Figur 1 mit TR bezeichnet. Vom Ausgang der Röntgeninspektionseinrichtung I führt ein erster Transportweg TR1 zu der Einrichtung T; auf diesem Transportweg werden Leiterplatten transportiert, die von der Röntgeninspektionseinrichtung I bzw. von der Datenverarbeitungseinrichtung C als fehlerfrei erkannt werden. Es kann aber auch vorgesehen sein, daß als fehlerfrei erkannte Leiterplatten der Reparaturstation SST zur Verifizierung der Fehlerfreiheit zugeführt werden.

Weiterhin führt vom Ausgang der Röntgeninspektionseinrichtung I ein zweiter Transportweg TR2 zu der Reparaturarbeitsstation SST; auf diesem Transportweg werden Leiterplatten transportiert, die von der Röntgeninspektionseinrichtung I bzw. von der Datenverarbeitungseinrichtung C als fehlerhaft erkannt werden. Nach der Reparatur können die Leiterplatten auf dem Tranportweg TR2 von der Reparaturarbeitsstation SST zu der Röntgeninspektionseinrichtung 1 rücktransportiert werden, wo sie wiederum einer Inspektion unterzogen werden.

Die Röntgeninspektionseinrichtung I kann in an sich bekannter Weise lötstellenindivudelle Informationen bilden, wobei für jede Lötstelle entweder die Information "Lötstelle fehlerfrei" oder die Information "Lötstelle fehlerhaft" gebildet wird. Außerdem mißt die Einrichtung I physikalische Parameter der Lötstellen, wie beispielsweise geometrische Abmessungen und/oder das Lotvolumen, und bildet entsprechende Meßwertinformationen. Zu jeder Lötstelle können eine Mehrzahl von Meßwertinformationen gebildet werden.

Die Einrichtung I verfügt hierzu über die entsprechende datenverarbeitende Funktionalität; alternativ hierzu wird die entsprechende Datenverarbeitung von der Einrichtung C durchgeführt.

Insgesamt stellt die in Figur 1 dargestellte Anordnung eine Regelanordnung dar, mit der Leiterplatten im Hinblick auf ihre Bestückung mit elektronischen Bauelementen vorbehandelt werden, bestückt, gelötet und auf ihre Qualität überprüft werden.

Die lötstellenindividuellen Qualitätsinformationen und/oder lötstellenindividuellen Meßwertinformationen, die gemessene physikalische Parameter überprüfter Lötstellen bezeichnen, werden zur Reparatur überprüfter fehlerhafter Lötstellen, zur Verifizierung überprüfter Lötstellen und/oder zur Steuerung der Herstellung weiterer Lötstellen on-line, also in dem laufenden Produktionsprozeß verwendet, in welchem die Lötstellen geprüft werden.

Beispielsweise werden das Lotvolumen der Lötstellen und/oder die Höhe mindestens eines Miniskus der Lötstellen und/oder Abmesssungen der Kontaktfläche der Lötstellen auf der Leiterplatte gemessen und aus diesen Meßwerten werden die Meßwertinformationen gebildet.

In diesem Zusammenhang ist weiterhin vorgesehen, daß anhand der lötstellenindividuellen Qualitätsinformationen und/oder anhand der lötstellenindividuellen Meßwertinformationen für fehlerhafte Lötstellen geprüft wird, was für ein Fehler vorliegt. Diese Prüfung kann mittels an sich bekannter Algorithmen erfolgen, die beispielsweise in der EP 0 236 001 B1 beschrieben sind. Zu diesen Fehlertypen gehören z.B. "Kaltlötstelle" und "falsche Positionierung einer Lötstelle".

Die Einrichtung I bildet sogenannte Tagfiles, d.h. Dateien, in der Fehlermeldungen für eine Leiterplatte (Board) enthalten sind.

Das dem Steuerwerk CPU der Datenverarbeitungseinrichtung C zugeordnete Steuerungsprogramm ordnet die erkannten Fehler jeweils einem Fehlertyp bzw. einer Fehlerklasse zu. Beispielsweise sind die Fehlerklassen "Lötpastenfehler", "Bestückungsfehler" und "Lötfehler" vorgesehen.

Beispielsweise sind die Fehler "Lotmangel" und "Lotüberschuß" Fehler der Fehlerklasse "Lötpastenfehler"; der Fehler "Versatz eines bestückten Bauteils" ist ein Fehler der Fehlerklasse "Bestückungsfehler"; und "Benetzungsfehler" (Lot verschmilzt nicht ordnungsgemäß mit Pin) ist ein Fehler der Fehlerklasse "Lötfehler".

s Eine fehlerhafte Lötstelle kann mehrere Fehler aufweisen, so daß einer solchen Lötstelle mehrere Fehlertypen bzw. Fehlerklassen zugeordnet werden.

In Abhängigkeit von der jeweiligen Fehlerklasse (Lötpastenfehler, Bestükkungsfehler, Lötfehler) führt die Datenverarbeitungseinrichtung der Einrichtung L, B oder R eine Steuerinformation zu. Hat die Datenverarbeitungseinrichtung z.B. einen Fehler der Fehlerklasse "Lötpastenfehler" erkannt, steuert sie die Einrichtung L an. Hat die Datenverarbeitungseinrichtung z.B. einen Fehler der Fehlerklasse "Lötpastenfehler" und zusätzlich einen Fehler der Fehlerklasse "Bestückungsfehler" erkannt, steuert sie die Einrichtung L und die Einrichtung B an. Die Steuerinformation kann beispielsweise aus einem Fehlerwarnsignal bestehen, das an den Einrichtungen L, B oder R oder an den zugeordneten Monitoren anzeigbar ist, oder aus Daten, die den Betrieb der jeweiligen Einrichtung modifizieren. Beispiele hierfür sind Änderungen der jeweils zugeführten Lötpastenmenge und Änderung der Temperatur des Lötmittels.

Ein Fehler kann mehrere Ursachen haben. Beispielsweise kann der Fehler "Lotmangel" auf einem "Lötpastenfehler" (= Fehler beim Auftragen von Lötpaste) und auf einem "Bestückungsfehler" (= Fehler beim Bestücken, z.B. Bauteil ist in der Weise versetzt, daß nur ein Teil der normalerweise zu benetzenden Fläche (lead) des Bauteils mit ausreichend Lot versorgt wird) beruhen, so daß in diesem Fall dem Fehler "Lotmangel" die beiden Fehlerklassen "Lötpastenfehler" und "Bestückungsfehler" zugeordnet wird.

Die Einrichtung I bildet für vorgebbare Stellen der zu prüfenden Leiterplatte mindestens einen Meßwert, wobei auch vorgesehen sein kann, daß für eine bestimmte Stelle der Leiterplatte eine Mehrzahl von Meßwerten gebildet wird. Die Einrichtung I gibt für jede vorgebbare Lötstelle eine Meßwertinformation bzw. eine Kombination ("Rule") von mehreren Meßwertinformationen an die Datenverarbeitungseinrichtung C.

Das dem Steuerwerk CPU der Datenverarbeitungseinrichtung C zugeordnete Steuerungsprogramm ist in der Weise ausgestaltet, daß jede Meßwertinformation mit einem Sollwert (Fehlergrenzwert) bzw. mit einer unteren und oberen Grenze eines zulässigen Bereichs verglichen wird. Die Sollwerte (Fehlergrenzwerte) bzw. die Grenzen zulässiger Bereiche sind vorgebbar oder stehen in einer festen Relation zu einem statistischen Mittelwert, der sich bei einem als gut erkannten Prozess ergeben hat. Es kann vorgesehen sein, daß die Grenzwerte meßwertartspezifisch nur um vorgebbare Bereiche von dem jeweiligen statistischen Mittelwert eines als gut erkannten Prozesses abweichen dürfen.

Besteht eine Meßwertinformationskombination z.B. aus drei Meßwertinformationen, so wird jeder der drei Meßwertinformationen mit seinem zugehörigen Sollwert (Fehlergrenzwert), der nicht überschritten oder nicht unterschritten werden darf, bzw. mit dem unteren und oberen Grenzwert eines zulässigen Bereichs verglichen.

Ergibt sich dabei, daß jede Meßwertinformation der Meßwertinformationskombination den zugehörigen Sollwert, der nicht überschritten werden darf, nicht überschreitet, bzw. den zugehörigen Sollwert, der nicht unterschritten werden darf, nicht unterschreitet, bzw. innerhalb der Grenzen des zulässigen Bereichs liegt, so wird die ("erste") lötstellenindividuelle Qualitätsinformation "Lötstelle fehlerfrei" gebildet. Andernfalls wird die ("zweite") lötstellenindividuelle Qualitätsinformation "Lötstelle fehlerhaft" gebildet.

Ist die zweite Qualitätsinformation "Lötstelle fehlerhaft" zu bilden, überschreitet also der Meßwert einen zulässigen oberen Grenzwert oder unterschreitet er einen zulässigen unteren Grenzwert, wird, sofern zu der betreffenden Lötstelle diejenige Meßwertinformation ermittelt, die von dem jeweiligen zugeordneten Grenzwert die größte relative Abweichung aufweist.

Ergibt sich dabei, daß z.B. die zweite Meßwertinformation der Meßwertinformationskombination die relativ größte Abweichung von seinem zugehörigen Sollwert aufweist, wird in Abhängigkeit dieser Meßwertinformation genau eine der Einrichtungen L, B, D oder R angesteuert.

Es kann kann vorgesehen sein, daß diejenigen zwei Meßwertinformationen einer Meßwertinformationskombination ermittelt werden, die die relativ größten Abweichungen jeweils von ihrem jeweiligen Fehlergrenzwert aufweisen. Gilt dies in dem Beispiel der aus drei Meßwertinformationen bestehenden Meßwertinformationskombination für die erste und die zweite Meßwertinformation, so wird in Abhängigkeit dieser beiden Meßwertinformationen (erste und zweite Meßwertinformation) genau die Einrichtung L, B, D oder R angesteuert, die für das Auftreten des betreffenden Fehlers ursächlich ist. Für das Auftreten von Meßwertinformationskombinationen können auch mehrere Einrichtungen L, B, D, R fehlerverursachend sein. In diesem Fall werden die entsprechenden Einrichtungen angesteuert.

Darüberhinaus lassen sich auch drei und mehr Meßwertinformationen einer Meßwertinformationskombination auf diese Weise auswerten, um jeweils diejenigen Einrichtungen L, B, D oder R anzusteuern, die für den jeweiligen Fehler ursächlich sind.

Die Fehlergrenz- bzw. Sollwerte sind vorgebbar und entsprechen vorzugsweise den statistischen Mittelwerten eines als gut erkannten Prozesses; jedoch können die Fehlergrenz- bzw. Sollwerte auch von diesen Mittelwerten abweichen.

Beträgt z.B. die Breite einer vorgebbaren Lötstelle im statistischen Mittel (im Scheitel der Gauß'schen Verteilung) x Millimeter, so können als Fehlergrenzwerte x + a, x - b, 1,1x, etc. vorgesehen werden. Damit können typische Fehlercharakteristika ausgefiltert werden, x kann 20 Millimeter und der vorgebbare untere Fehlergrenzwert kann 16 Millimeter (x = 4 Millimeter) betragen. Ein aktueller Meßwert mit 18 Millimeter wird dann als ausreichend bewertet. Die relative Abweichung des aktuellen Meßwerts vom Fehlergrenzwert beträgt dann (18-16)/18 x 100 % = + 11,11%.

Zum Beispiel besteht eine Meßwertinformationskombination aus folgenden drei Meßwertinformationen:
- Meßwertinformation 1:: measured_width (gemessene Lötstellenbreite) = 22 Millimeter
- Meßwertinformation 2:: heel solder (Lötmenge) entsprechend 6000 normierte Grauwertanteile in einem definierten Prüffenster
- Meßwertinformation 3:: heel pad delta (Lotmeniskushöhe) = 1500 Mikrometer.

Die statistischen Mittelwerte betragen z.B.
bei der Meßwertinformation 1: 20 Millimeter
bei der Meßwertinformation 2: 10000 normierte Grauwertanteile
bei der Meßwertinformation 3: 3000 Mikrometer.

Damit ergibt sich für die Meßwertinformation 3 die größte relative Abweichung.
Dieser Meßwertinformation 3 ist eine erste Information zugeordnet, die den Fehler "Lötfehler" und "Lötpastenfehler" kennzeichnet. Mit der ersten Information werden die Einrichtungen L und R angesteuert.

Werden bei diesem Beispiel die beiden Meßwertinformationen mit den größten relativen Abweichungen ermittelt, so sind dies die Meßwertinformation 3 und die Meßwertinformation 2. Dieser Kombination der Meßwertinformationen 3 und 2 ist eine zweite Information zugeordnet, die den Fehler "Lötfehler" kennzeichnet. Mit dieser zweiten Information wird die Einrichtung R angesteuert.

Wertet man alle drei Meßwertinformationen der Kombination aus, wird dieser Kombination eine dritte Information zugeordnet, die ebenfalls den Fehler "Lötfehler" kennzeichnet. Mit der dritten Information wird ebenfalls die Einrichtung R angesteuert.

Die erste, zweite und dritte Information gibt zunächst an, welche der Einrichtungen L, B, D oder R angesteuert wird. Weiterhin gibt die erste, zweite und dritte Information jeweils eine Steuergröße an, d.h. Betriebsparameter bzw. Betriebsparameteränderungen der jeweiligen Einrichtung (z.B. Erhöhung oder Verringerung der aufzutragenden Lötpastenmenge, Erhöhung oder Verringerung des aufzutragenden Lots).

Den drei Fehlerklassen "Bestückungsfehler", "Lötpastenfehler" und "Lötfehler" sind mehrere (z.B. die folgenden) Fehlertypen zugeordnet:

| | |
|---|---|
| "Ben.Gullw. | A", (Benetzung Gullwing) |
| "Ben.J-Bein | B", (Benetzung J-Bein) |
| "Ben.quad.SMD | C", (Benetzung quaderförmiger SMD) |
| "SMD_versetzt | D", |
| "sonst.Loetf. | E", |
| "nicht_geloetet | F", |
| "Lotbrücke | G", |
| "wegg./hochg. | H", (Anschlußpin weggebogen/hochgebogen) |
| "SMD_versetzt | I", |
| "sonst.Loetf. | J", |
| "Lotperlen | K", |
| "INSUFF_TOE | L", (magere Lötstelle) |
| "Blase.SMD | V", (Lötblase). |

Weiterhin kann vorgesehen sein, daß die erkannten Fehler bzw. Meßwertinformationen einem Fehlertyp - wie z.B. vorstehend aufgelistet - zugeordnet werden und daß die Fehlertypen einer Fehlerklasse (Lötpastenfehler, Bestükkungsfehler, Lötfehler) zugeordnet werden.

Die lötstellenindividuellen Qualitätsinformationen und/oder die lötstellenindividuellen Meßwertinformationen, die die gemessenen physikalischen Parameter überprüfter Lötstellen bezeichnen, und/oder statistische Informationen über die Häufigkeit des Auftretens von Fehlern werden auf den Monitoren LMON, BMON, RMON angezeigt, die den Einrichtungen L, B, R zugeordnet sind.

Die Datenverarbeitungseinrichtung C und die Reparaturarbeitsstation SST können beispielsweise in folgenden zwei Varianten ausgeführt werden:

### 1. PC-Variante

| | |
|---|---|
| CPU | HP Vectra VL2 4/66 |
| | HP Vectra VL2 5/60 |
| Hauptspeicher | 24 MB |
| Festplatte | 500 MB |
| Swap | 60 MB |
| Grafikkarte | Ultra VGA 1024x768 B |
| Monitor | 15" oder 17" |
| Betriebsystem | Solaris x86 2.4 |
| Netzwerkkarte | 16-Bit BNC, TP, AOI |

### Optionen

| | |
|---|---|
| Eingabe | Numerisches Keypad Trackball |
| | RS-232 Barcodescanner |
| Lichtzeiger | Heeb OM-500 |
| | Royonic 500 |
| Drucker | HP DeskJet 1200C/PS |
| | HP LaserJet 5MP |
| Datensicherung | Magnetband (QIC oder DAT) |
| | Magneto-Optische Laufwerke |

### 2. Workstation-Variante

| | |
|---|---|
| CPU | Sun SparcStation 4 |
| | Sun SparcStation 5 |
| Hauptspeicher | 32 MB |
| Festplatte | 1 GB |
| Swap | 60 MB |
| Grafikkarte | 1024x768, 1152x900 Bildpunkte |
| Monitor | 15" oder 17" |
| Betriebsystem | Solaris 2.4 |
| Netzwerkkarte | eingebaut |

### Optionen

| | |
|---|---|
| Eingabe | 3 1/2" Diskettenlaufwerk |
| | Numerisches Keypad |
| | RS-322 Barcodescanner |
| Lichtzeiger | Heeb OM-500 |
| | Royonic 500 |
| Drucker | HP DeskJet 1200C/PS |
| | HP LaserJet 5MP |
| Datensicherung | Magnetband (QIC oder DAT) |
| | Magneto-Optische Laufwerke |

Das das erfindungsgemäße Verfahren definierende Steuerungsprogramm ist beispielsweise eine UNIX-Applikation, die auf dem Betriebssystem Solaris von SunSoft aufsetzt.

Das Steuerungsprogramm realisiert unter anderem:
a) eine Anzeige der von der Einrichtung I generierten Röntgeninspektionsergebnisse;
b) eine Anzeige der bei der Röntgeninspektion gefundenen Fehler schrittweise in einer grafischen Darstellung des Leiterplattenlayouts;
c) eine Anzeige der bei der Röntgeninspektion gefundenen Fehler schrittweise mit Hilfe eines Laser/Licht-Zeigers auf der Originalleiterplatte;
d) eine Anzeige von Fehlern (Häufung von Fehlern an einer oder mehreren Stellen der Leiterplatte) in einer grafischen Darstellung des Leiterplattenlayouts;
e) eine Verifizierung, Quittierung und Weiterverarbeitung der bei der Röntgeninspektion gefundenen Fehler, gegebenenfalls schrittweise durch eine Bedienperson des Reparaturarbeitsplatzes SST mit einem Dialogmenü; und
f) Speicherung bearbeiteter Fehlerdaten als Schnittstelle zu einem Programmodul (definiert in Anspruch 8) oder zu Qualitätssicherungssystemen.

Im folgenden werden die vorstehend genannten Elemente des Steuerungsprogramms beschrieben:

### a) Anzeige der von der Einrichtung I generierten Röntgeninspektionsergebnisse in Textform.

Diese Anzeige erfolgt auf dem Monitor SMON der Reparaturarbeitsplatzstation SST.

Der Programmarbeitsbereich besteht aus einem Hauptfenster mit Menüleiste. Weitere Fenster können eingeblendet werden.

Die Menüleiste umfaßt folgende Menüs mit den Optionen:

| • Datei | Dateifunktionen |
|---|---|
| **Editor** | Aufruf eines Texteditors |
| **Beenden** | Programm verlassen |

| **• Betriebsart** | Auswahl der Betriebsarten |
|---|---|
| **Einzelfehler** | Einzel fehleranzeige |
| **Fehlerübersicht** | Anzeige der Fehlerübersicht |
| **Röntgenbild** | Darstellung des Röntgenbildes |

| **• Konfiguration** | Konfigurationseinstellungen |
|---|---|
| **Licht-/Laserzeiger >** | Auswahl des Licht-/Laserzeigers |
| **Royonic 500** | Lichtzeiger Royonic 500 |
| **Heeb Laser** | Heeb LL-2A oder OM-500 |

| **Betriebsart >** | Einstellen der Standardbetriebsart(en) |
|---|---|
| **Einzelfehler** | Einzelfehleranzeige |
| **Fehlerübersicht** | Fehlerübersicht |
| **Röntgenbild** | Röntgenbildfenster |

| **Dateipfade** > | Angabe der Dateipfade |
|---|---|
| **CXI-Tag-Dateien** | Pfad zu den CXI-Tag-Dateien |
| **Röntgenbilddateien** | Pfad zu den Röntgenviews |
| **CAD-Dateien** | Pfad zu den CAD-Dateien |
| **Ergebnisdateien** | Pfad zu den Ergebnisdateien |
| **Fehlertypreferenz** | Pfad zur Fehlertypreferenzdatei |

| **Verifizierdialog >** | |
|---|---|
| **GUT-Boards autom.** | Fehlerlose Boards automatisch überneh- |
| | men |

| **Optionen** > | Optionsmenü für diverse Einstellungen |
|---|---|
| **Symbolleiste** | Symbolleiste ein- und ausblenden |
| **Speichern bei Beenden** | Einstellungen bei Beenden speichern |

Die zuvor beschriebene Menüleiste wird bei geänderten oder zusätzlichen Bedienschritten entsprechend angepaßt.

### b) Anzeige der bei der Röntgeninspektion gefundenen Fehler schrittweise in einer grafischen Darstellung des Leiterplattenlayouts

### b1) Betriebsart: Einzelfehleranzeige

Die Steuerung der Einzelfehleranzeige durch den Bediener der Reparaturarbeitsstation SST erfolgt mit einem Dialogfenster, das die Elemente
- Kopfbereich (Header),
- Optionsgruppe Anzeige,
- Optionsgruppe Seite,
- Fehlerliste,
- Knöpfe Weiter, Zurück, Echter Fehler, Pseudofehler, Neuer Fehler, Fehlertyp ändern, Bauteil weiter, Fertig, Abbruch,
enthält.

Im "Kopfbereich (Header)" werden die Daten aus dem Kopf der Daten des Röntgensystems I angezeigt.

Mit der "Optionsgruppe Anzeige" kann der Bediener die Anzeigeformen für die Einzelfehleranzeige auswählen. Zur Verfügung stehen die Möglichkeiten "**Layout**", für die Darstellung des grafischen Leiterplattenlayouts auf dem Bildschirm, und "**Zeiger**", für die Anzeige auf der Originalleiterplatte mit einem Licht-/Laserzeiger.

Mit Hilfe der "Optionsgruppe Seite" wird die angezeigte Seite der Leiterplatte ausgewählt. Zur Verfügung stehen **Oberseite** und **Unterseite**.

Die "Fehlerliste" enthält alle vom Röntgensystem gefundenen oder vom Bediener hinzugefügten Fehler der Leiterplatte. Der aktuell im Leiterplattenlayout und/oder vom Licht-/Laserzeiger angezeigte Fehler ist in der Fehlerliste hervorgehoben.

Der Knopf "Weiter" zeigt den nächsten Fehler in der Fehlerliste im Leiterplattenlayout und/oder mit dem Licht-/Laserzeiger an.

Der Knopf "Zurück" zeigt den vorhergehenden Fehler in der Fehlerliste im Leiterplattenlayout und/oder dem Licht-/Laserzeiger an.

Der Knopf "Echter Fehler" markiert den aktuellen Fehler als echten Fehler.

Der Knopf "Pseudofehler" markiert den aktuellen Fehler als Pseudofehler.

Der Knopf "Neuer Fehler" fügt einen neuen Fehler in die Liste ein und zeigt ihn im Leiterplattenlayout und/oder mit dem Licht-/Laserzeiger an.

Der Knopf "Fehlertyp ändern" gestattet es, den Fehlertyp eines bereits markierten Fehlers wieder zu ändern.

Der Knopf "Bauteil weiter" springt zum nächsten Bauteil in der Fehlerliste. Wird diese Taste gedrückt, werden die Einzelfehler gelöscht und der Fehlercode für den Bauteilsummenfehler in die Ergebnisdatei eingetragen.

Der Knopf "Fertig" oder die Taste "Enter" nach dem letzten Fehlereintrag trägt die markierten echten Fehler und die markierten Pseudofehler in die Ergebnisdatei ein und schließt den Verifiziervorgang für diese Baugruppe ab. Bei vorzeitigem Abbruch wird in die Ergebnisdatei als letzte Zeile eine Abbruchmeldung eingetragen (siehe auch Knopf "Abbruch").

Der Knopf "Abbruch" schließt das Dialogfenster und das Fenster mit dem grafischen Leiterplattenlayout und/oder fährt den Licht-/Laseranzeiger in eine Ruheposition. In die Ergebnisdatei (siehe unten) wird als letzte Zeile eine Abbruchmeldung eingetragen.

Über eine standardisierte Softwareschnittstelle wird der ausgewählte Fehler an die Programmodule für die Anzeige im grafischen Leiterplattenlayout und mit dem Licht-/Laserzeiger übergeben.

Ist die Anzeige des Leiterplattenlayouts aktiviert, so wird jeder Fehler in der Fehlerliste durch eine Markierung in einem grafischen Leiterplattenlayout, das aus leiterplattenbeschreibenden CAD-Daten erzeugt wird, angezeigt. Eine Anzeige ist in Figur 2 dargestellt, wobei beispielsweise der mit dem (externen) Pfeil markierten Lötstelle in der tatsächlichen Bildschirmanzeige eine Markierung zugeordnet ist, die in Figur 2 nicht erkennbar ist.

In einer Standardeinstellung werden alle Baugruppen der Leiterplatte im grafischen Layout angezeigt. Fehlerdaten werden über eine standardisierte Softwareschnittstelle entgegengenommen und die entsprechenden Fehler werden angezeigt. Fehler werden farblich hervorgehoben.

Es kann die gesamte Leiterplatte oder lediglich ein Ausschnitt, vorzugsweise in vergrößertem Maßstab, dargestellt werden.

### b2) Betriebsart: Fehlerübersicht

Diese Betriebsart ermöglicht es, auf einer grafischen Darstellung des Leiterplattenlayouts die markierten echten Fehler der Fehlerliste zusammen oder getrennt nach Fehlern darzustellen.

Die Fehler, die die Einrichtung I erkennt, werden den Fehlertypen "Bestükkungsfehler", "Lötfehler" und "Lötpastenfehler" zugeordnet. "Bestückungsfehler" werden in blauer Farbe, "Lötfehler" in gelber Farbe und "Lötpastenfehler" in grüner Farbe dargestellt.
Im Fenster wird angezeigt, auf welcher Seite (Oberseite/Unterseite) der Leiterplatte sich die Bauelemente befinden.

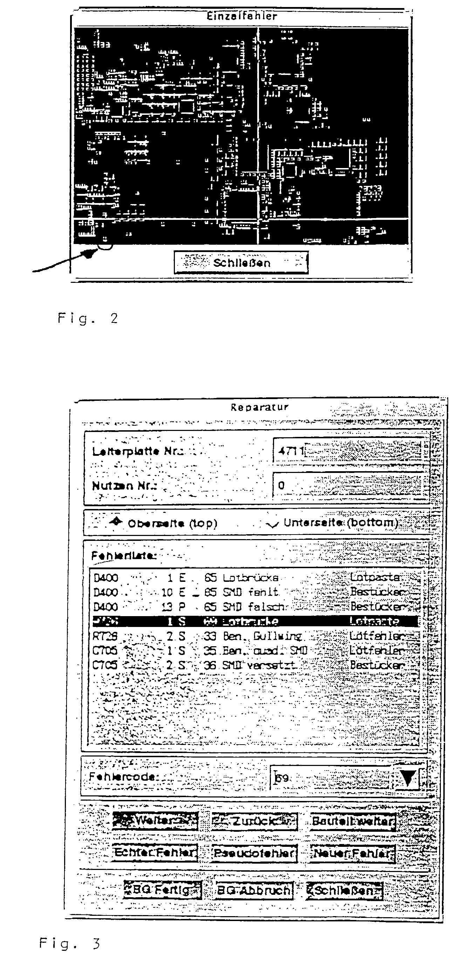

In Figur 3 ist ein Beispiel einer auf dem Bildschirm angezeigten Fehlerliste dargestellt.

### b3) Betriebsart: Röntgenbildanzeige

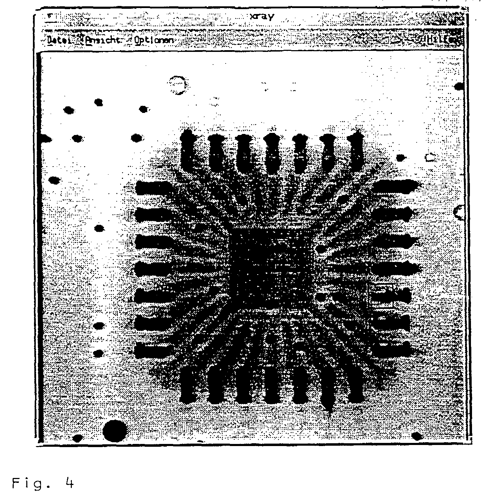

In einem gesonderten Fenster kann zu den von der Einrichtung I generierten Daten das passende Röntgenbild dargestellt werden. Ein Beispiel eines solchen Fensters ist in Figur 4 dargestellt, wobei eine fehlerhafte Lötstelle rechts im Fenster mit einem quadratischen Rahmen markiert ist. Optional kann in dieses Fenster die komplette Bauteileliste des Bildes eingeblendet werden.

### c) Anzeige der bei der Röntgeninspektion gefundenen Fehler schrittweise mit Hilfe eines Laser/Licht-Zeigers auf der Originalleiterplatte;

Ist im Dialogfenster die Anzeige mit dem Licht-/Laserzeiger aktiviert, so wird der Fehler auf der Originalleiterplatte mit einem Lichtpunkt angezeigt. Beispielsweise können die Licht-/Laserzeiger Royonic Lichtzeiger 500 oder Heeb Laserlite LL-2-A bzw. 500 verwendet werden.

### d) Anzeige von Fehlern (Häufung von Fehlern an einer oder mehreren Stellen der Leiterplatte) in einer grafischen Darstellung des Leiterplattenlayouts;

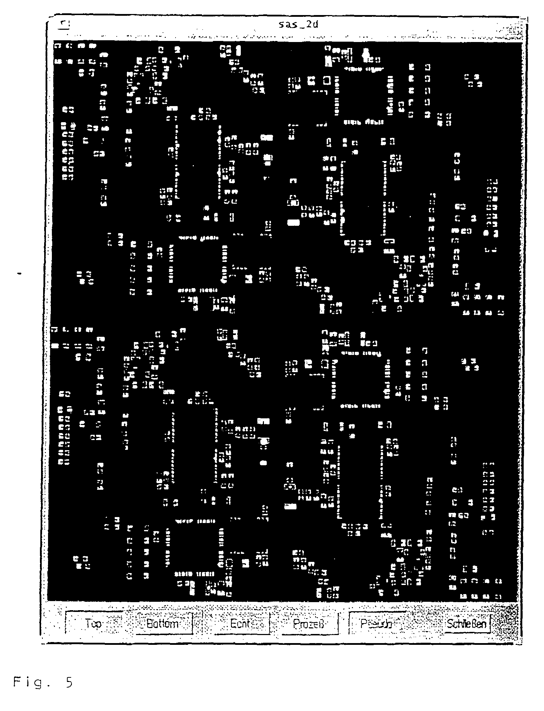

Ein Beispiel einer derartigen Anzeige ist in Figur 5 dargestellt, wobei in der Figur 5 die eigentlichen Fehlerdaten, die den zugehörigen Lötstellen bei der tatssächlichen Bildschirmanzeige benachbart zugeordnet sind, nicht erkennbar sind.
Weitere Anzeigen von Fehlern in statistischer Auswertung sind in den Figuren 6, 7 und 8 dargestellt.

### e) Verifizierung, Quittierung und Weiterverarbeitung der bei der Röntgeninspektion gefundenen Fehler, gegebenenfalls schrittweise durch eine Bedienperson der Reparaturarbeitsstation SST mit einem Dialogmenü.

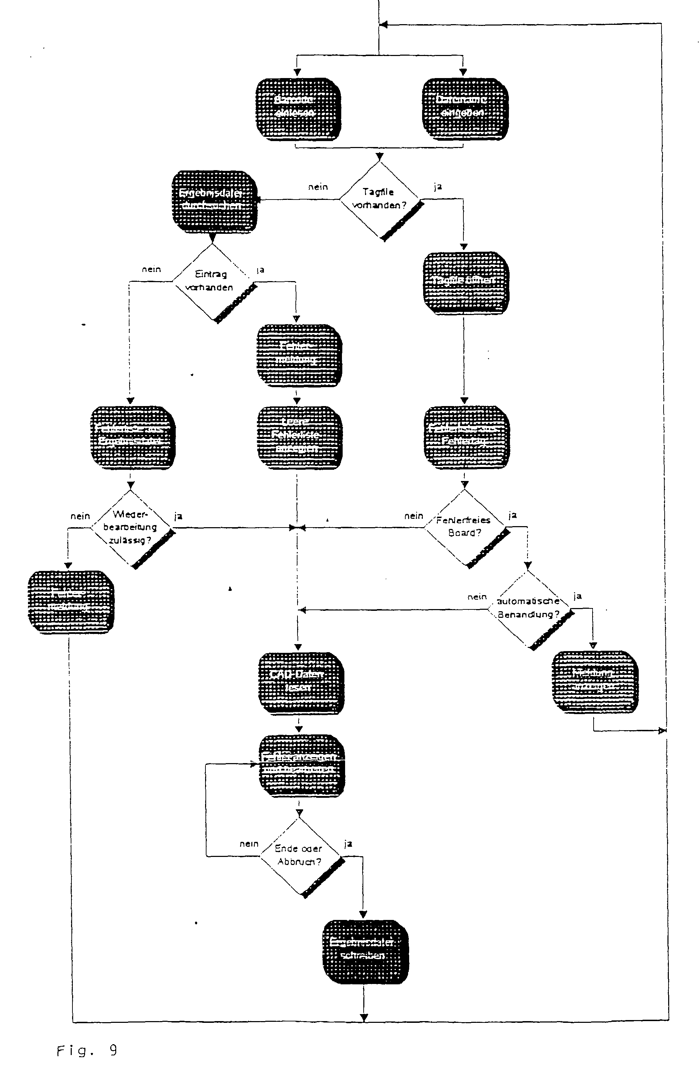

Im folgenden wird der Ablauf eines Zyklus im Zusammenhang mit der Verifizierung fehlerfreier Leiterplatten und der Reparatur fehlerhafter Leiterplatten beschrieben, der auch in Figur 9 dargestellt ist.

Für die Verifizierung und Reparatur von Leiterplatten muß die Betriebsart Einzelfehleranzeige aktiviert sein. Ein Reparaturzyklus beginnt mit dem Einlesen der Leiterplattennummer mit einem Barcode-Lesestift.

Alternativ kann die Reparatur auch mit der Selektion einer Fehlertag-Datei über Tastatur oder Maus beginnen.

Anhand der eingelesenen Leiterplattennummer wird das zugehörige Tagfile für die Leiterplatte gesucht, geöffnet und der Dateikopf und die Fehlerliste eingelesen. Handelt es sich um eine fehlerfreie Leiterplatte, so werden in Abhängigkeit des Schalters GOOD_BOARDS zwei Fälle unterschieden:
- GOOD_BOARDS=AUTO
   Es wird eine Meldung angezeigt, daß die Leiterplatte fehlerfrei ist, und es wird automatisch ein Eintrag in der Ergebnisdatei erzeugt bzw. eine neue Ergebnisdatei angelegt, in der die fehlerfreie Leiterplatte vermerkt ist.
- GOOD_BOARDS = MANU
   Es wird wie bei fehlerhaften Leiterplatten fortgefahren mit der Ausnahme, daß die Fehlerliste leer ist.

Bei einer fehlerhaften Leiterplatte werden anhand der im Dateikopf des Tagfiles enthaltenen Baugruppen-Ident-Nummer die CAD-Dateien gesucht, geöffnet und die Geometriedaten der Baugruppe eingelesen. Ist die Baugruppen-Ident-Nummer der aktuellen Leiterplatte mit der zuvor geprüften identisch, so entfällt das erneute Einlesen der Geometriedaten.

Die Fehlerliste wird im Dialogfenster angezeigt, der erste Fehler markiert und auf dem Leiterplattenlayout auf dem Bildschirm und/oder mit dem Licht-/Laserzeiger angezeigt.

Mit Hilfe der im Abschnitt *"Einzelfehleranzeige"* beschriebenen Schaltflächen des Dialogfensters können die Fehler in der Liste nun vom Bediener klassifiziert und markiert werden. Nachdem ein Fehler markiert ist, wird automatisch zum nächsten Fehler gesprungen. Hat der Bediener alle Fehler in der Liste markiert (bearbeitet) bzw. mit *"Bauteil weiter"* als Summenfehler markiert, so werden diese in die Ergebnisdatei eingetragen.

Nach der Bearbeitung des Boards werden die leiterplattenbezogenen Testdateien (I-Tag-Dateien, Röntgenbilder) entfernt, wenn ein Schalter DEL_TAG=On gesetzt ist. Standardwert ist DEL_TAG=Off.

Ist für das Aktuelle Board kein Test-Tag vorhanden, wird die Ergebnisdatei nach einem Eintrag für dieses Board bzw. das entsprechende Verzeichnis nach einer Ergebnisdatei für dieses Board durchsucht und wie folgt verfahren:
- Ausgabe einer Fehlermeldung, wenn das Board auch in der Ergebnisdatei nicht vorhanden ist bzw. wenn für dieses Board keine eigene Ergebnisdatei existiert.
- Handelt es sich um ein fehlerfreies Board, zu dem die Tag-Datei vorhanden ist, so wird in Abhängigkeit von dem Schalter BOOD_BOARDS wie oben beschrieben verfahren.
- Handelt es sich um die erneute Bearbeitung des Boards (keine Tag-Datei, aber Eintrag in der Ergebnisdatei bzw. eigene Ergebnisdatei), so wird die weitere Arbeitsweise vom Schalter REWORK_BOARDS beeinflußt. Lautet der Eintrag in der Konfigurationsdatei REWORD_BOARDS=On so kann die Leiterplatte nochmals unter Verwendung der Fehlerdaten aus der Ergebnisdatei bearbeitet werden. Ist der Eintrag dagegen REWORK_BOARDS=Off, so wird eine Meldung ausgegeben, daß das wiederholte Bearbeiten nicht möglich ist.

### f) Speicherung bearbeiteter Fehlerdaten als Schnittstelle zu einem Programmodul (definiert in Anspruch 8) oder zu Qualitätssicherungssystemen.

Die Datenverarbeitungseinrichtung C bearbeitet u.a. Bestückdaten mit den folgenden Feldern:

| **Feldname** | **Datenformat** | **Beschreibung** |
|---|---|---|
| **Joint** | long int | fortlaufende Nummer der Lötstelle (1 bis max_joint) |
| **Pin / Device** | long int | fortlaufende Nummer der Pins pro Bauteil (1 bis max_pin) |
| **Pin X** | long int | X-Koordinate des Pins bezogen auf den Boardnullpunkt |
| **Pin Y** | long int | Y-Koordinate des Pins bezogen auf den Boardnullpunkt |
| **Pad X** | long int | Padlänge in X-Richtung |
| **Pad Y** | long int | Padlänge in Y-Richtung |
| **Seite** | char | Baugruppenseite (T \| B) |
| **Device Name** | char[15] | Bezeichnung des Bauteils (ohne '\0') |
| **Device Typ** | char[25] | Bezeichnung des Bauteiltyps (ohne '\0') |
| **View** | long int | fortlaufende Nummer der View (1 bis no_of_views) |
| **View X** | long int | X-Koordinate des Pins bezogen auf die View |
| **View Y** | long int | Y-Koordinate des Pins bezogen auf die View |

Weiterhin bearbeitet die Datenverbeitungseinrichtung C eine Fehlertypenreferenzdatei.

Wie bereits beschrieben, wird jedem von der Einrichtung I erkannten Fehler eine Fehlerklasse "Bestückungsfehler", "Lötfehler" und "Lötpastenfehler" zugeordnet. Der Inhalt der Datei gliedert sich in einzelne Datensätze mit z.B. vier Datenfeldern. Jede Zeile der Datei beschreibt eine Referenz. Die Felder haben folgende Bedeutung:

| **Feldname** | **Feldlänge** | **Beschreibung** |
|---|---|---|
| **Fehler** | 3 Zeichen (long) | Fehlernummer |
| **Fehlernachricht** | 20 Zeichen | laut Defect-Tag |
| **Fehlerklasse** | 3 Zeichen (long) | Fehlerklasse |
| **Fehlerklassennachricht** | 20 Zeichen | Meldung für Bildschirmausgaben |
| **Farbe** | 10 Zeichen | Farbe, mit der dieser Fehler auf dem Bildschirm angezeigt wird. |
| **Symbol** | 10 Zeichen | Symbol, das zur Darstellung des Fehlers am Licht-/Laserzeiger verwendet wird. |

Ein Beispiel einer Fehlertypenreferenzdatei ist folgendermaßen ausgestaltet:

| | | | |
|---|---|---|---|
| #Fehlertyp | Fehlerklasse | Farbe | Symbol |
| 65;2503 Lotbrücke | a;l;Lötfehler; | gelb; | Punkt |
| 40;2503_Ben.Gullw. | H;l;Lötfehler; | gelb; | Punkt |
| 18;3208Reihe versetzt | 2;4;Bestückungsfehler; | blau; | Pfeil |

Für jede Leiterplatte kann eine eigene Ergebnisdatei erzeugt werden. Alternativ hierzu kann eine gemeinsame Ergebnisdatei für eine Mehrzahl bearbeiteter Leiterplatten, insbesondere für alle bearbeiteten Leiterplatten erzeugt werden. Für beide Arten von Ergebnisdateien erzeugt jeder Fehler einen Eintrag in dieser Datei.

Für die behandelte Baugruppe wird zunächst ein Header-Datensatz erstellt, der aus folgenden Feldern besteht:

| **Feldname** | **Feldlänge** | **Beschreibung** |
|---|---|---|
| **Datensatztyp** | 1 Zeichen | immer "H" bei Headerzeile |
| **Seriennummer der Baugruppe** | 25 Zeichen | laut Defect-Tag bzw. Barcode |
| **Nutzen ID** | 2 Zeichen (long) | laut Defect-Tag |
| **Baugruppentyp** | 20 Zeichen | laut Defect-Tag |
| **Testsystem ID** | 12 Zeichen | laut Defect-Tag |
| **Datum der Inspek- tion** | tt:mm:jj | laut Defect-Tag |
| **Uhrzeit der Inspektion** | hh:mm:ss | laut Defect-Tag |
| **UserID des Prüfers** | 4 Zeichen (long) | laut/etc./passwd Datei |
| **Datum der Reparatur** | tt:mm:jj | laut Systemzeit |
| **Uhrzeit der Reparatur** | hh:mm:ss | laut Systemzeit |
| **Status** | 1 Zeichen (long) | 0 = keine Reparatur; 1, 2... Anzahl der Reparaturen |

Im Anschluß an diese Headerzeile folgt für jeden Fehler eine Datenzeile, die aus den folgenden Feldern besteht.

| **Feldname** | **Feldlänge** | **Beschreibung** |
|---|---|---|
| **Datensatz- typ** | 1 Zeichen | immer "D" bei Datenzeile |
| **Bauteilname** | 15 Zeichen | laut Defect-Tag |
| **Pinnummer** | 3 Zeichen (long) | laut Defect-Tag |
| **Fehlercode 1** | 3 Zeichen (long) | laut Fehlercode-Tabelle |
| **Fehlercode 2** | 3 Zeichen (long) | laut Eingabe des Prüfers |
| **Rule** | 2 Zeichen (long) | laut Defect-Tag (DL-Feld) |
| **Fehlerklasse** | 3 Zeichen (long) | laut Referenztabelle |
| **Fehlerstatus** | 2 Zeichen (long) | Code (0 = bestätigt, 1 = geändert, 2 = Pseudo) |

Das vorstehend beschriebene Verfahren kann eines von mehreren Programmodulen des dem Steuerwerk CPU zugeordneten Steuerungsprogramms sein. Das vorzugsweise modular aufgebaute Steuerungsprogramm kann weitere Programmodule aufweisen, die Gegenstand der nebengeordneten Ansprüche 5, 8 und 10 bzw. der von diesen abhängigen Ansprüchen sind. Jedes Programmodul ist für sich alleine oder zusammen mit einem oder mehreren anderen Programmodulen einsetzbar.

Ein Programmodul des Steuerungsprogramms ist wie bereits beschrieben in der Weise ausgestaltet, daß die von der Einrichtung I erzeugten Röntgenbilder bzw. aus diesen erzeugte elektronische Bilder und aus CAD-Daten erzeugte Bilder des grafischen Layouts der Leiterplatten auf dem Monitor SMON an der Reparaturarbeitsstation SST anzeigbar sind.

Dabei werden die Röntgenbilder bzw. die elektronischen Bilder sowie die Leiterplattenlayout-Bilder gemeinsam mit lötstellenindividuellen Meßwertinformationen angezeigt, die gemessene, physikalische Parameter überprüfter fehlerhafter Lötstellen bezeichnen, gegebenenfalls gemeinsam mit statistischen Informationen über die Häufigkeit des Auftretens von Fehlern. Die Informationen werden in alphanumerischer Darstellung und/oder in Symboldarstellung in den Röntgenbildern dargestellt.

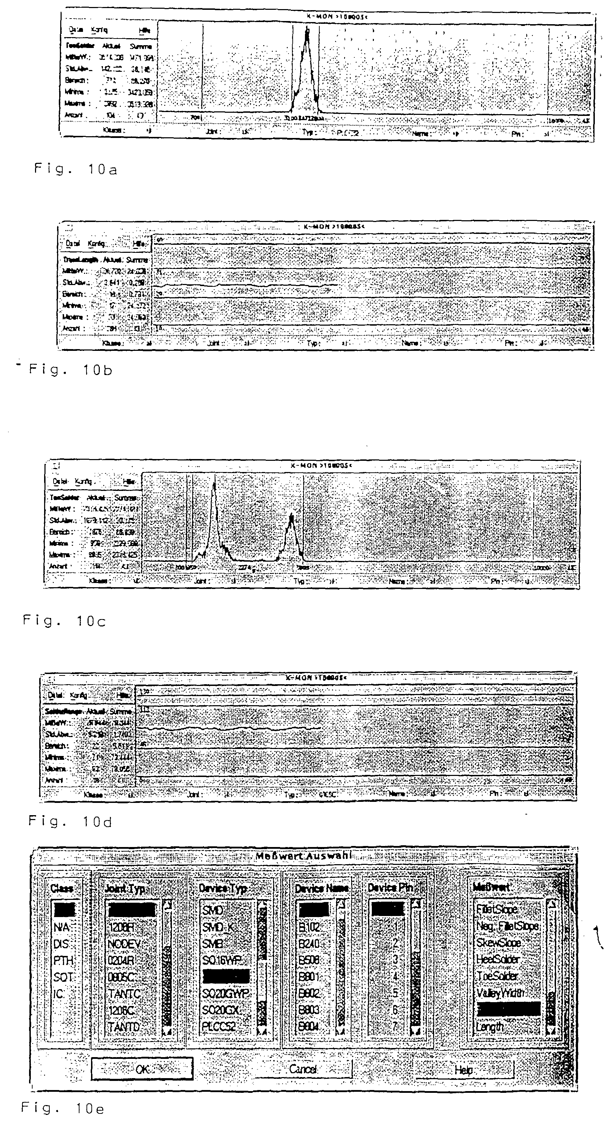

Ein weiteres Programmodul des Steuerungsprogramms ist in der Weise ausgestaltet, daß die lötstellenindividuellen Qualitätsinformationen und/oder lötstellenindividuellen Meßwertinformationen, die gemessene physikalische Parameter überprüfter Lötstellen bezeichnen, mit vorgebbaren Herstellungsprozeßschwellwerten verglichen werden, und daß. in Abhängigkeit des Vergleichs, Prozeßsteuerdaten gebildet werden. Beispielsweie wird als Herstellungsprozeßschwellwert eine bestimmte Lotmenge vorgegeben, die pro vorgebbarer Lötstelle aufzubringen ist. Ergibt sich anhand eines Vergleichs dieses Herstellungsprozeßschwellwerts bzw. Herstellungsprozeßreferenzwerts mit den entsprechenden Lotmengen-Meßwertinformationen, daß dieser Schwell- bzw. Referenzwert um einen vorgebbaren Toleranzbereich über- oder unterschritten wird, bildet die Datenverarbeitungseinrichtung C alphanumerische und/oder grafische Informationen, die den Referenzwert, und/oder die Meßwertinformationen und/oder den Umfang des Über- bzw. Unterschreitens des Referenzwerts bezeichnen. Weiterhin kann die Datenverarbeitungseinrichtung diejenige Einrichtung(en) (L, B, R) bestimmen, die das Über- bzw. Unterschreiten der Lotmengen verursachen. Diese Informationen werden dem Monitor SMON der Reparaturarbeitsstation SST und dem Monitor derjenigen Einrichtung (z.B. R) zugeführt, die das Über- bzw. Unterschreiten der Lotmengen verursacht. Entsprechende Bildschirmanzeigen sind in Figur 10 dargestellt.

Weiterhin kann die Datenverarbeitungseinrichtung C eine Steuerinformation für diese Einrichtung (z.B. R) bilden, die eine Änderung der Betriebsparameter dieser Einrichtung bewirken. Wird beispielsweise der Referenzwert in einem bestimmten Umfang überschritten, werden die Steuerinformationen (d.h. Prozeßsteuerdaten) in der Weise gebildet, daß die Einrichtung R die Lotmenge pro Lötstelle entsprechend reduziert. Diese Prozeduren, die zur unmittelbaren Steuerung des laufenden Herstellungsprozesses durchgeführt werden, können bereits vor dem Auftreten von Lötfehlern on-line durchgeführt werden, also zu Zeitpunkten, zu denen noch Qualitätsinformationen "Lötstelle fehlerfrei" gebildet werden.

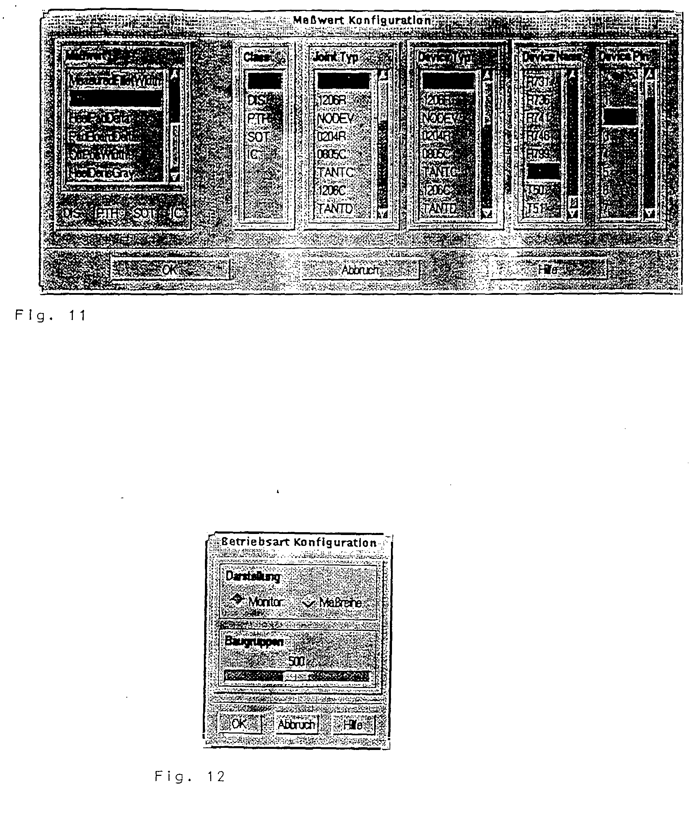

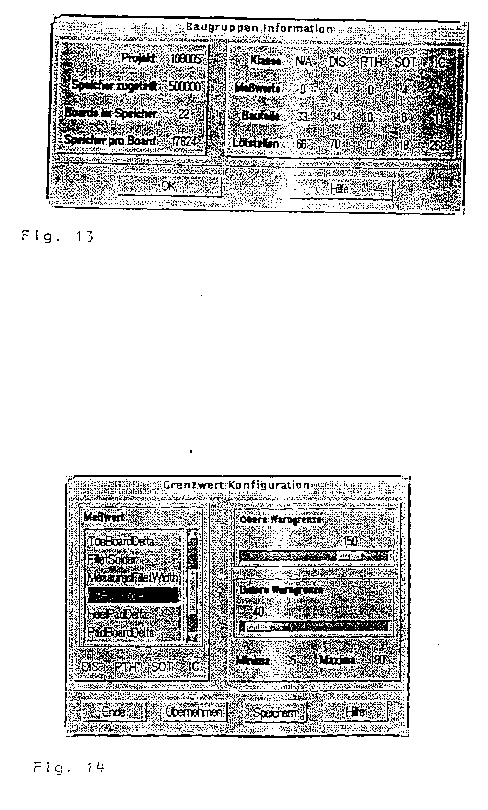

Bildschirmanzeigen im Zusammenhang mit der Konfiguration von Meßwerten bzw. von Referenzwerten ("Obere Warngrenze", "Untere Warngrenze") sind in den Figuren 11 bis 14 dargestellt.

Anhand der lötstellenindividuellen Qualitätsinformationen und/oder anhand der lötstellenindividuellen Meßwertinformationen wird also für Lötstellen, deren physikalische Parameter von den vorgebbaren Herstellungsprozeßschwellbzw. -referenzwerten abweichen, geprüft, welcher der ersten und/oder der zweiten und/oder der dritten Einrichtung L, B, R diese Abweichung zuzuordnen ist. In Abhängigkeit dieser Zuordnung wird die erste und/oder die zweite und/oder die dritte Einrichtung (L, B, R) gegebenenfalls auch die zugehörige optische Anzeigeeinrichtung (LMON, BMON, RMON) mit den Prozeßsteuerdaten angesteuert. Den Anzeigeeinrichtungen werden insbesondere die von der Datenverarbeitungseinrichtung C gebildeten alphanumerischen und/oder grafischen Informationen zugeführt, die den Referenzwert und/oder die Meßwertinformationen und/oder den Umfang des Über- bzw. Unterschreitens des Referenzwerts bezeichnen.

Im Rahmen des erfindungsgemäßen Verfahrens werden also lötstellenindividuelle Meßweninformationen on-line ausgewertet und an unterschiedliche Einrichtungen des Herstellungsprozesses übertragen. Röntgen-Fehlerbilder werden on-line am Reparaturarbeitsplatz genutzt. Qualitätsinformationen, und zwar u.a. Meßwertinformationen werden zu einzelnen Fertigungsschritten bzw. den entsprechenden Einrichtungen zugeordnet und dort angezeigt. Durch Rückkopplung dieser Informationen wird der Fertigungsprozeß geregelt. Weiterhin wird on-line eine layoutorientierte Statistik durchgeführt. Schließlich werden unter Verwendung von bauteilrelevanten Daten und von statistisch aufbereiteten Meßwertinformationen lötstellentyp-bezogene Gesetzmäßigkeiten für die Erkennung von Lötfehlern und Prozeßgrenzwerten definiert.

## Patentansprüche

1. Verfahren zur Prüfung von Lötstellen auf Leiterplatten, wobei die Qualität der Lötstellen mittels Röntgenstrahlung auf Fehler überprüft wird,
wobei lötstellenindividuelle Qualitätsinformationen gebildet werden,
wobei Röntgenbilder der Löstellen generiert werden und
wobei die Röntgenbilder und/oder Bilder des grafischen layouts der leiterplatten auf einer optischen Anzeigeeinrichtung (SMON) an einer Reparaturarbeitsstation (SST) angezeigt werden.
wobei auf der optischen Anzeigeeinrichtung (SMON) die Röntgenbilder und/oder Bilder des grafischen Layouts der Leiterplatten, die eine fehlerhafte Lötstelle aufweisen, mit einer Markierung des Orts der fehlerhaften Lötstelle auf der Leiterplatte und gemeinsam mit zugehörigen Fehlerdaten angezeigt werden.

2. Verfahren nach Anspruch 1, dadurch gekennzeichnet, daß die Röntgenbilder und/oder die Bilder des grafischen Layouts der Leiterplatten gemeinsam mit lötstellenindividuellen Meßwertinformationen, die gemessene physikalische Parameter überprüfter fehlerhafter Lötstellen bezeichnen, und/oder mit statistischen Informationen über die Häufigkeit des Auftretens von Fehlern angezeigt werden.

3. erfahren nach einem der vorstehenden Ansprüche, dadurch gekennzeichnet, daß die Fehlerdaten benachbart zu den zugehörigen Lötstellen angezeigt werden.

4. Verfahren nach einem der vorstehenden Ansprüche, dadurch gekennzeichnet, daß die Informationen in alphanumerischer Darstellung und oder in Symboldarstellung in den Röntgenbildern dargestellt werden.

5. Anordnung zur Prüfung von Lötstellen auf Leiterplatten, bestehend aus
einer Einrichtung (I) zur Überprüfung der Qualität der Lötstellen mittels Röntgenstrahlung auf Fehler,
wobei die Einrichtung lötstellenindividuelle Qualitätsinformationen bildet und Röntgenbilder der Lötstellen generiert,
einer optischen Anzeigeeinrichtung (SMON) an einer Reparaturarbeitsstation (SST) welche die Röntgenbilder und/oder Bilder des grafischen layouts der Leiterplatten anzeigt, und einem Steuenverk (CPU) mit einem zugeordneten Steuerprogramm, das den Betrieb der Reparaturarbeitsstation (SST) definiert.
wobei das Steuerprogramm in der Weise ausgestaltet ist, daß auf der optischen Anzeigeeirinchtung (SMON) die Röntgenbilder und/oder Bilder des grafischen Layouts der Leiterplatten, die eine fehlerhafte Lötstelle aufweisen, mit einer Markierung des Orts der fehlerhaften Lötstelle auf der Leiterplatte und gemeinsam mit zugehörigen Fehlerdaten angezeigt werden.

6. Anordnung nach Anspruch 5, dadurch gekennzeichnet, daß das Steuerprogramm weiterhin in der Weise ausgestaltet ist, daß die optische Anzeigeeinrichtung (SMON) die Röntgenbilder und/oder Bilder des grafischen Layouts der Leiterplatten gemeinsam mit lötstellenindividuellen Meßwertinformationen, die gemessene physikalische Parameter überprüfter fehlerhafter Lötstellen bezeichnen, anzeigt, und/oder daß die optische Anzeigeeinrichtung (SMON) die Röntgenbilder und/oder die Bilder des grafischen Layouts der Leiterplatten gemeinsam mit statistischen Informationen über die Häufigkeit des Auftretens von Fehlern anzeigt.

7. Anordnung nach Anspruch 5 oder 6, dadurch gekennzeichnet, daß das Steuerprogramm weiterhin in der Weise ausgestaltet ist, daß die Fehlerdaten benachbart zu den zugehörigen Lötstellen angezeigt werden.

8. Anordnung nach einem der Ansprüche 5 bis 7, dadurch gekennzeichnet, das Steuerprogramm weiterhin in der Weise ausgestaltet ist, daß die optische Anzeigeeinrichtung (SMON) die Informationen in alphanumerischer Darstellung und/oder in Symboldarstellung in den Röntgenbildern darstellt.

## Claims

1. Process for testing solder joints on printed circuit boards, the quality of the solder joints being checked for defects by means of X-rays,
solder-joint-specific quality information being formed,
X-ray images of the solder joints being generated and
the X-ray images andlor images of the graphical layout of the printed circuit boards being displayed on a visual display device (SMON) at a repair workstation (SST),
the X-ray images andlor images of the graphical layout of the printed circuit boards which have a defective solder joint being displayed on the visual display device (SMON), with a marking of the location of the defective solder joint on the printed circuit board and together with associated defect data.

2. Process according to Claim 1, characterized in that the X-ray images andlor the images of the graphical layout of the printed circuit boards are displayed together with solder-joint-specific measured value information which characterizes measured physical parameters of checked defective solder joints, and/or with statistical information about the frequency of occurrence of defects.

3. Process according to one of the preceding claims, characterized in that the defect data are displayed adjacent to the associated solder joints.

4. Process according to one of the preceding claims, characterized in that the information is displayed alphanumerically and/or symbolically in the X-ray images.

5. Arrangement for testing solder jointson printed circuit boards, comprising a device (I) for checking the quality of the solder joints for defects by means of X-rays,
the device forming solder joint specific quality information and generating X-ray images of the solder joints,
a device (I) for checking the quality of the solder joints for defects by means of X-rays,
the device forming solder joint specific quality information and generating X-ray images of the solder joints,
a visual display device (SMON) on a repair workstation (SST), the device displaying the X-ray images and/or images of the graphical layout of the printed circuit boards, and
a controller (CPU) having an associated control program which defines the operation of the repair workstation (SST),
the control program being configured in such a way that the X-ray images andlor images of the graphical layout of the printed circuit boards which have a defective solder joint are displayed on the visual display device (SMON), with a marking of the location of the defective solder joint on the printed circuit board and together with associated defect data.

6. Arrangement according to Claim 5, characterized in that the control program is also configured in such a way that the visual display device (SMON) displays the X-ray images and/or images of the graphical layout of the printed circuit boards together with solder-joint-specific measured value information which characterizes measured physical parameters of checked defective solder joints, and/or that the visual display device (SMON) displays the X-ray images andlor the images of the graphical layout of the printed circuit boards together with statistical information about the frequency of occurrence of defects.

7. Arrangement according to Claim 5 or 6, characterized in that the control program is also configured in such a way that the defect data are displayed adjacent to the associated solder joints.

8. Arrangement according to one of Claims 5 to 7, characterized in that the control program is also configured in such a way that the visual display device (SMON) displays the information alphanumerically andlor symbolically in the X-ray images.

## Revendications

1. Procédé pour tester des soudures sur des cartes imprimées,
la qualité des soudures étant examinée par rayonnement X pour détecter des défauts,
des informations relatives à la qualité de chaque soudure étant créées,
des radiographies des soudures étant générées et
lesdites radiographies et/ou images de layout graphique des cartes imprimées étant affichées sur un dispositif d'affichage optique (SMON) prévu sur un poste de travail de réparation (STT),
sur ledit dispositif d'affichage optique (SMON), les radiographies et/ou images de layout graphique des cartes imprimées, qui présentent une soudure défectueuse, étant affichées avec un repère du lieu de la soudure défectueuse sur la carte imprimée et ensemble avec des données de défectuosité associées.

2. Procédé selon la revendication 1, caractérisé en ce que les radiographies et/ou les images de layout graphique des cartes imprimées sont affichées ensemble avec des informations sur les valeurs mesurées de chaque soudure, qui désignent des paramètres physiques mesurés de soudures défectueuses examinées, et/ou avec des informations statistiques sur la fréquence de l'apparition de défauts.

3. Procédé selon l'une des revendications précédentes, caractérisé en ce que les données de défectuosité sont affichées au voisinage des soudures associées.

4. Procédé selon l'une des revendications précédentes, caractérisé en ce que les informations sont représentées sous forme alphanumérique et/ou sous forme de symboles dans les radiographies.

5. Arrangement pour tester des soudures sur des cartes imprimées, comprenant
un dispositif (I) pour examiner la qualité des soudures par rayonnement X pour détecter des défauts,
ledit dispositif créant des informations relatives à la qualité de chaque soudure et générant des radiographies des soudures,
un dispositif d'affichage optique (SMON) prévu sur un poste de travail de réparation (STT), qui affiche les radiographies et/ou images de layout graphique des cartes imprimées, et
une unité de commande (CPU) avec un programme de commande associé qui définit le fonctionnement de la station de travail de réparation (STT),
ledit programme de commande étant réalisé de telle façon que les radiographies et/ou images de layout graphique des cartes imprimées, qui présentent une soudure défectueuse, sont affichées avec un repère du lieu de la soudure défectueuse et ensemble avec des données de défectuosité associées.

6. Arrangement selon la revendication 5, caractérisé en ce que le programme de commande est en outre réalisé de telle façon que le dispositif d'affichage optique (SMON) affiche les radiographies et/ou images de layout graphique des cartes imprimées ensemble avec des informations sur les valeurs mesurées de chaque soudure, qui désignent des paramètres physiques mesurés de soudures défectueuses examinées, et/ou que le dispositif d'affichage optique (SMON) affiche les radiographies et/ou images de layout graphique des cartes imprimées ensemble avec des informations statistiques sur la fréquence de l'apparition de défauts.

7. Arrangement selon la revendication 5 ou 6, caractérisé en ce que le programme de commande est en outre réalisé de telle façon que les données de défectuosité sont affichées au voisinage des soudures associées.

8. Arrangement selon l'une des revendications 5 à 7, caractérisé en ce que le programme de commande est en outre réalisé de telle façon que le dispositif d'affichage optique (SMON) affiche les informations sous forme alphanumérique et/ou sous forme de symboles dans les radiographies.
